(19) Europäisches Patentamt / European Patent Office / Office européen des brevets

(11) **EP 2 049 304 B1**

(12) **EUROPEAN PATENT SPECIFICATION**

(45) Date of publication and mention
of the grant of the patent:
**12.11.2014 Bulletin 2014/46**

(51) Int Cl.:
*B24D 3/00* *(2006.01)*       *B24D 3/32* *(2006.01)*
*B24B 37/24* *(2012.01)*       *H01L 21/304* *(2006.01)*

(21) Application number: **07768835.6**

(86) International application number:
**PCT/KR2007/003513**

(22) Date of filing: **20.07.2007**

(87) International publication number:
**WO 2008/013377 (31.01.2008 Gazette 2008/05)**

(54) **CHEMICAL MECHANICAL POLISHING PADS COMPRISING LIQUID ORGANIC MATERIAL CORE ENCAPSULATED IN POLYMER SHELL AND METHODS FOR PRODUCING THE SAME**

KISSEN ZUM CHEMISCH-MECHANISCHEN POLIEREN MIT EINEM KERN AUS FLÜSSIGEM ORGANISCHEM MATERIAL, DER IN EINEM POLYMERMANTEL EINGESCHLOSSEN IST, UND VERFAHREN ZU DEREN HERSTELLUNG

TAMPONS DE POLISSAGE MÉCANIQUE ET CHIMIQUE COMPRENANT UN NOYAU DE MATÉRIAU ORGANIQUE LIQUIDE ENCAPSULÉ DANS UNE COQUE DE POLYMÈRE ET PROCÉDÉS DE PRODUCTION DE CES TAMPONS

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **24.07.2006   KR 20060069164**

(43) Date of publication of application:
**22.04.2009   Bulletin 2009/17**

(73) Proprietor: **SKC Co., Ltd.**
**Gyeonggi 440-745 (KR)**

(72) Inventors:
• **JUN, Sung-Min**
  **Choongcheongbook-do 361-240 (KR)**
• **LIM, Jong-Soo**
  **Daejeon 305-801 (KR)**
• **BAE, Seung-Hun**
  **Seoul 140-724 (KR)**
• **LEE, Ju-Yeol**
  **Gyeonggi-do 463-805 (KR)**
• **PARK, In-Ha**
  **Ulsan 680-779 (KR)**

(74) Representative: **Nederlandsch Octrooibureau**
**P.O. Box 29720**
**2502 LS The Hague (NL)**

(56) References cited:
JP-A- 11 285 961       JP-A- 2000 033 552
KR-A- 20010 055 971    KR-A- 20020 094 923

EP 2 049 304 B1

## Description

## Technical Field

The present invention relates to a chemical mechanical polishing (CMP) pad, and more particularly, to a CMP pad formed of a polymer matrix containing a liquid organic material encapsulated in a polymer shell and a method of producing the same.

## Background Art

Generally, a polishing process includes abrading a rough surface to form a flat surface such as glass. While repetitively and regularly polishing a surface of an object with a polishing pad, a fine-grain slurry existing in an interface between the polishing pad and the object allows the object to be polished. Particularly, in a process of manufacturing a semiconductor, since planarization of a wafer has a great effect on semiconductor integration, a chemical mechanical polishing (CMP) process has to be performed for wafer planarization.

There are three conventional methods in technology with respect to polishing pads used in a CMP process.

One is a urethane pad filled with one of natural felt such as wool, natural weaved fiber, felt polyester mixed with urethane, and all kinds of fillers. Another is a polishing pad including bubbles or pores capable of storing slurry without a filler. The other is a polishing pad using a uniform polymer matrix with micro holes capable of storing slurry.

With respect to the urethane pad, U.S. Patent No. 4,927,432 discloses a polishing pad formed of polyester felt mixed with urethane to use pores and projected fibers. Though the pad described above shows excellent flatness, since the pad has low hardness, a polishing speed is low.

With respect to the another pad, U.S. Patent No. 5,578,362 discloses a polishing pad with a surface structure of a sunken portion in a semicircular shape formed by mixing polyurethane with a hollow spherical subsidiary. Such pads have been generally used due to excellent polishing speed and flatness. However, when mixing with the different subsidiary, uniform distribution is difficult due to low density of the subsidiary, which makes it difficult to uniformly prepare a pad with a regular density deviation. Also, as polishing progresses, an error of flatness increases. Due to the hollow shape, it is difficult to prepare a pad with a high hardness to improve polishing efficiency.

U.S. Patent No. 6,685,540 discloses a polishing pad using solid-phase polymer as a filler. However, there is no site for collecting slurry in the pad, thereby deteriorating polishing efficiency.

Also, U.S. Patent No. 6,790,883 discloses a polishing pad formed by mixing water-soluble organic and inorganic materials with a polymer matrix. An empty space of materials solved in water acts as a pore capable of collecting slurry. However, there is needed a time for generating a space for collecting slurry, thereby causing deterioration of polishing efficiency. Also, a life of the pad is short due to deterioration of property of matter, due to water solubility of water-soluble materials.

Also, Korean Patent No. 0495404 discloses a polishing pad including embedded liquid micro elements and a method of producing the polishing pad. It is described that a process of producing the polishing pad is easy since all elements used in the producing process are liquid. However, it has been known that the embedded liquid micro elements initially mixed with a urethane polymer matrix do not have a certain size. Therefore, it is required to control a size of a space for collecting slurry, which is formed by the liquid micro elements, during a urethane reaction. Since it is required to form uniform slurry collecting spaces within a short urethane reaction time, liquid incompatible with urethane is required and it is difficult to control the size of uniform slurry collecting spaces with a small change in a producing process. Also, since liquid incompatible with a polymer matrix is used, adhesive strength is deteriorated due to a phenomenon in which liquid material is transferred toward a surface of the pad. Also, a life of the pad is short due to deterioration of properties of the urethane matrix and hardness of the pad itself is reduced since only liquid exists in the space. Therefore, it is difficult to satisfy a requirement of wafer planarization in a semiconductor process.

Also, Korean Patent Publication No. 2001-0005435 discloses urethane moldings for a polishing pad, the urethane molding prepared by mixing and hardening one of expan ded micro hollow spheres and micro globoids expandable without foam when applying heat, and water with an isocynate group terminal prepolymer and compounds containing active hydrogen. However, there is problem in which bubbles generated by micro globoids and water are expanded or foamed during a urethane reaction, thereby deforming bubbles to weaken density and hardness thereof. Also, since gases are used as slurry collecting spaces, hardness and density of the pad are not increased.

U.S. Patent No. 6,777,455 discloses a polishing pad of micro urethane foam prepared by mixing inert gases. In this case, it is difficult to increase hardness of a polishing pad itself prepared by mixing inert gases, dishing and erosion may be caused due to low hardness, in a CMP process, and it is difficult to improve flatness of wafers.

In addition, there is a polishing pad of uniform urethane without bubbles, the pad given a polishing function by using a surface texture. However, the pad makes a scratch on a polished surface of an object and has a low polishing speed due to insufficient amount of slurry during a polishing process.

Up to now, polishing pads, whose elasticity and hardness are given thereto by mixing, solidifying, and impregnating pores, a filler, and nonwoven, the pads using a polyurethane polymer matrix considering easiness of production, are generally used. Also, pads including some of heterogeneous materials as described above, pores, bubbles, and a different material capable of forming a concave portion during a CMP process, in addition to a polyurethane matrix, are commonly used in planarization process of several semiconductor processes or glass.

However, when a polyurethane matrix includes pores or bubbles, deviation of density increases due to heterogeneity of distribution, thereby generating a difference in a polishing function for each lot and a difference in density for each portion in the same lot and a problem of an error in flatness, the error increasing as the polishing process progresses.

Together with improvement of semiconductor processes, there is required a polishing pad having excellent functions such as high polishing efficiency, stable polishing function, flatness of wafers, and convenience in producing pads.

To satisfy a level of requirements for high-integration and planarization of semiconductors, which increases day by day, it is necessary that polishing pads have a high hardness, high polishing efficiency, and a stable polishing function. However, generally, though polishing efficiency of pads is high, the polishing efficiency is deteriorated as time goes by. Also, it is difficult to stably prepare the pads with a high hardness and high density, due to a low density of hollow subsidiary materials.

On the other hand, urethane polishing pads without bubbles, with stable polishing function, are capable of having a high hardness and high density and maintaining flatness of wafers. However, polishing efficiency of the pads is relatively low.

Disclosure of Invention

Technical Problem

As described above, it is difficult that general polishing pads satisfy the level of requirements for high integration and high planarization of semiconductors, increased day by day.

Accordingly, an aspect of the present invention provides a polishing pad with a high hardness, high density, high polishing efficiency, and stable polishing function and a method of producing the polishing pad, together with convenience of producing the po lishing pad.

**Technical Solution**

According, to an aspect of the present invention, there is provided a chemical mechanical polishing (CMP) pad including a core of a polymer shell encapsulating a liquid organic material with one of a boiling point and a decomposition point of 130 °C or more in a polymer matrix, the CMP pad having open pores formed by the core on a polishing surface thereof.

The polymer shell may have a density of 0.5 to 1.5 g/cm$^3$.

The polymer shell may be selected from a group consisting of polystyrene-acrylate copolymer, polyacrylonitrile, polyacrylate, polycarbonate, silicone, epoxy, polyurethane, polyester, nylon, polyvinylchloride, polystyrene, polypropylene, polyethylene, acrylic resin, and a mixture thereof.

The liquid organic material may be selected from a group consisting of one of a hydrocarbon solvent and a modified hydrocarbon solvent formed of a mixture of CnHm in which n is an integer from 9 to 16; phthalate plasticizers; liquid oligomers with a molecular weight about 10,000 or less and a viscosity about $5 \times 10^8$ cps/20°C or less; solvents with a high boiling point such as N,N-dimethylformamide (DMF); and a mixture thereof.

The phthalate plasticizers may be selected from a group consisting of dioctyl phthalate, diisononyl phthalate, dioctyl adipate, trioctyl trimellitate, dibutyl phthalate, and diisodecyl phthalate. The liquid oligomers may be selected from a group consisting of polypropylene glycol, polyethylene glycol, polymethylene glycol, ester polyol, carbonate polyol, poly hanstoff dispersion, and polyisocyanate polyaddition.

The polymer matrix may be selected from a group consisting of polyurethane, polyester, nylon, acryl, epoxy, silicone, polycarbonate, and a mixture thereof.

The core may be contained in the polymer matrix by 1 to 200 part per hundred resin (phr).

The core may have a size of 1 to 200 $\mu$m.

The pad may have a hardness of 60 Shore D or more.

According to another aspect of the present invention, there is provided a method of producing a CMP pad, the method including: producing a polymer matrix by a two-liquid casting method using a main material and a hardener; and mixing the polymer matrix with a core of a polymer shell encapsulating a liquid organic material.

More preferably, the core of the polymer shell encapsulating the liquid organic material may be mixed with at least one of the main material and the hardener.

## Brief Description of the Drawings

FIG 1 is a schematic diagram illustrating a polishing pad according to an exemplary embodiment of the present invention; and
FIG 2 is a graph illustrating decreases in hardnesses of polishing pads.

## Best Mode for Carrying Out the Invention

Hereinafter, an exemplary embodiment of the present invention will be described in detail referring to the attached drawings.

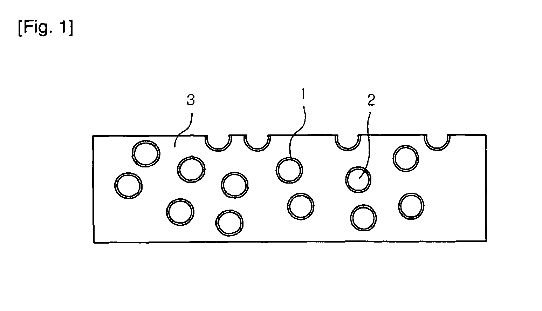

FIG 1 is a schematic diagram illustrating a chemical mechanical polishing (CMP) pad formed of a polymer matrix 3 including a core in the form of a polymer shell 1 encapsulating a liquid organic material 2

In the present invention, a polymer matrix may be formed of one of polyurethane, polyester, nylon, acryl, epoxy, silicone, polycarbonates, and a mixture thereof. Particularly, the polymer matrix may be formed of the polyurethane.

The polyurethane may be prepared by casting two liquids formed of a main material and hardeners. When mixing the main material with the hardeners, the core containing the liquid organic material encapsulated in the polymer shell may be mixed with at least one of the main material and the hardeners.

In the polymer matrix, the core in the form of the polymer shell encapsulating the liquid organic material is contained, thereby increasing a hardness of the polishing pad to more than 60 D and exposing and opening the core in the pad to continuously provide a space for storing slurry as the pad is abraded, during a polishing process.

It is impossible to obtain a polishing pad with a high hardness and high density by using conventional hollow pores. According to an exemplary embodiment of the present invention, a polishing pad with a high hardness and high density by containing a core encapsulating a liquid organic material may be obtained and a uniform polishing pad may be prepared by mixing materials having a similar density to each other. In addition, though after a large amount of time is taken up with polishing processes, it may be controlled that a bottom of the polishing pad prepared as described above is softened by attacks of slurry and the hardness of the pad itself is deteriorated as time goes by, thereby obtaining stable polishing efficiency.

A polymer material with a similar density to the polymer matrix, such as urethane may be used as the polymer shell to reduce defects in mixture of the matrix and reduce a flatness deviation of wafers. In detail, the density may be 0.5 to 1.5 g/cm$^3$. Also, as the polymer shell may be formed of the polymer shell is selected from a group consisting of polystyrene-acrylate copolymer, polyacrylonitrile, polyacrylate, polycarbonate, silicone, epoxy, polyurethane, polyester, nylon, polyvinylchloride, polystyrene, polypropylene, polyethylene, acrylic resin, and a mixture thereof. Particularly, the polymer shell may be polyacrylate.

The liquid organic material may be selected from a group consisting of one of a hydrocarbon solvent and a modified hydrocarbon solvent, which is a mixture of $C_n H_m$ in m which n is an integer from 9 to 16 such as CX-2100, CX-2500, and CX-2700 produced by Hosung Chemex Co., Ltd; phthalate plasticizers such as dioctyl phthalate, diisononyl phthalate, dioctyl adipate, trioctyl trimellitate, dibutyl phthalate, and diisodecyl phthalate; liquid oligomers with a molecular weight about 10,000 or less and a viscosity about $5\times10^8$ cps/20°C or less and a decomposition point of 130°C or more; which is a modified polyol such as polypropylene glycol, polyethylene glycol, polymethylene glycol, ester polyol, carbonate polyol, poly hanstoff dispersion, and polyisocyanate polyaddition; solvents with a high boiling point such as N,N-dimethylformamide (DMF); and a mixture thereof.

Also, a boiling point or decomposition point may be more than 130°C, and more particularly, more than 160°C, which is not easily volatilized by polymerization heat of the polymer matrix. When the boiling point of the liquid organic material is lower than 130°C, a polishing pad with a high density and high hardness may not be obtained due to a deformation of the core during a urethane reaction.

The core may be contained in the polymer matrix by 1 to 200 phr, and more particularly, 10 to 60 phr based on the polymer matrix. When an amount of the core is less than 1 phr, polishing characteristics such as a polishing speed and a level of flatness are low. When the amount of the core is more than 200 phr, it is difficult to stably prepare polishing pads and to obtain stable polishing efficiency since uniform distribution of the core is difficult.

A size of the core may be 1 to 200 $\mu$m, and more particularly, 10 to 70 $\mu$m. When the size is less than 1 $\mu$m, the polishing characteristics such as a polishing speed and flatness are not improved due to a small amount of polishing slurry. When the size is more than 200 $\mu$m, it is not suitable for urethane moldings for polishing pads.

Examples

Hereinafter, the present invention will be described in detail with reference to examples. However, the present invention will not be limited to the examples.

Example 1

Poly(tetramethylene glycol) (PTMEG) (a functional group 2, Mw=1000) of 1000 g were poured into a reaction vessel, and methylenediphenyl diisocynate (MDI) of 1262 g were poured into the reaction vessel. A prepolymer, a main material, with both terminals formed of isocynates was prepared by stirring the two liquids for three hours at a temperature of 80°C. Hereto, 500 g of MS-220D Dongjin Semichem Co., Ltd. that was a liquid organic material encapsulated in a polymer shell was poured and mixed using a high-speed mixer. MS-220D was a core formed of a polyacrylate shell encapsulating a liquid organic material that was a mixed solvent of hydrocarbon liquid organic materials $C_n H_m$ in which n is an integer from 9 to 16 with a boiling point of 160°C or more.

A hardener to be mixed with the main material was prepared by pouring and heating 4,4'-methylene-bis (0-chloroaniline) of 1080 g into the vessel at a temperature of 130°C for three hours and removing pores therefrom.

The main material was mixed with the hardener by using a high-speed mixer by an equivalent of urethane reaction as 1:1 and poured into an open circular mold of 25 inches to be hardened. A urethane cake prepared as described above was left as it was at a temperature of 80°C for 24 hours and was perfectly reacted to be ripened.

In this case, the prepared polyurethane had a density of 1.105 g/cm$^3$ and a hardness of 67 D by Shore D A mass of the polyurethane was cut and sliced into a length of 20 inches. A groove formed in an XY shape with a width of 400 $\mu$m and a pitch of 0.5 inches was formed on a surface of the polyurethane by using a laser. A polishing pad was prepared by attaching a buffer pad to a bottom of the polyurethane by using a double stick tape.

Example 2

A urethane cake was prepared by using a method similar to that of Example 1, exclusive of an input amount of MS-220D In this case, the input amount was 1000 g.

Example 3

A urethane cake was prepared by using a method similar to that of Example 1, exclusive of an input amount of MS-220D In this case, the input was 1500 g.

Example 4

A polishing pad was prepared by preparing a urethane cake by using a method similar to that of Example 1 and simultaneously forming a micro hole with a size of 180 $\mu$m and a pitch of 300 $\mu$m and a groove by using a laser on a surface thereof.

In this case, the polyurethane cake had a density of 1.1 g/cm$^3$ and a hardness of 66 Shore D

Comparative Example 1

A urethane cake was prepared by using a method similar to that of Example 1, exclusive of a core of a polymer shell encapsulating the liquid organic material.

In this case, the polyurethane cake had a density of 1.145 g/cm$^3$ and a hardness of 68 D by Shore D The polyurethane cake was cut and sliced into a length of 20 inches. A micro hole with a size of 180 $\mu$m and a pitch of 300 $\mu$m was formed on a surface of the polyurethane by using a laser. After that, a polishing pad was prepared by attaching a buffer pad to a bottom of the polyurethane by using a double-stick tape.

Comparative Example 2

A mixture was prepared by mixing 500 weight percent of polyether prepolymers formed of Uniroyal ADIPENE™ L-325 and an isocynate group having a concentration of 2.2 meg/g with 13 g of EXPANCEL 551DE that was a micro shell formed of a copolymer, of chloride vinylidene and acrylonitrile, decompressing to remove pores therefrom, and adding 145 g of 4,4'-methylene-bis (0-chloroaniline) previously melted at a temperature of 120°C thereto while stirring. The mixture was stirred for about 1 minute, put into an open circular mold, and ripened in an oven at a temperature of 100°C for six hours, thereby obtaining a polyurethane micro foam block with a cell diameter of 40 $\mu$m. The obtained

polyurethane micro foam block had a density of 0.75 g/cm$^3$. A groove was formed by using a laser.

Performances of polishing pads prepared by Examples 1 to 4 and Comparative Examples 1 and 2, respectively, were tested. As conditions applied to a chemical-mechanical polishing (CMP) process of the prepared pads, AVANTI-472 (IPEC Co., Ltd.) was used as a CMP machine, silica slurry (Cheil Industries, Starplanar-4000) was used as slurry, an amount of flow was 200 ml/minute, a polishing load was 7 psi, the polishing pad rotated 46 times per minute, and a wafer rotated 38 times per minute. Under the conditions as described above, uniformity in wafer, an average of polishing speed, and a number of scratches were measured. A result of the measurement is shown in Table 1.

Overage Polishing Speed

The average of polishing speed was tested by polishing a silicone wafer of 8 inches, the wafer coated with a thermal oxide layer of 1 $\mu$m (10,000 Å), under the described polishing conditions for one minutes.

Uniformity in Wafer

The uniformity in wafer was obtained by measuring a thickness of a layer at 98 locations in wafer after polishing a silicone wafer of 8 inches, the wafer coated with a thermal oxide layer of 1 $\mu$m (10,000 Å), under the described polishing conditions for one minutes. The uniformity in wafer was obtained by an equation as follows.

$$\text{Uniformity in wafer (\%)} = (\text{maximum thickness} - \text{minimum thickness})/2 \times \text{average layer thickness} \times 100 \quad \text{Equation}$$

Number of Scratches

The number of scratches was obtained by measuring a number of micro scratches formed on one wafer by using KLA (TENCOR Co., Ltd. KLA2112) after polishing a silicone wafer of 8 inches, the wafer coated with a thermal oxide layer of 1 $\mu$m (10,000 Å), under the described polishing conditions for one minutes, and cleaning and drying the wafer. As a number of the scratches is smaller, the polishing pad has more excellent performance. A number of the scratches, which can be commercially available, may be less than 500.

Table 1

[Table 1]

[Table]

| | Hardness(Shore D) | Density(g/cm$^3$) | Additives Contents(phr) | Uniformity in Wafer (%) | AverageP olishingSp eed (Å/min) | Number of Scratches(Number per Wafer) |
|---|---|---|---|---|---|---|
| Example 1 | 67 D | 1.105 | 15 | 3.5% or less | 2500 | 130 |
| Example 2 | 66 D | 1.00 | 30 | 3.5% or less | 2600 | 120 |
| Example 3 | 65 D | 0.95 | 45 | 3.5% or less | 2700 | 80 |
| Example 4 | 66 D | 1.10 | 30 | 4.0% or less | 2555 | 100 |
| Comp.Example 1 | 68 D | 1.145 | 0 | 4.5% or less | 2450 | 130 |
| Comp.Example 2 | 54 D | 0.75 | - | 5.0% or less | 2550 | 190 |

As shown in Table 1, the polishing pads obtained by Examples 1 to 4 have a high hardness and high density than those of Comparative Example 2 and have more excellent values than those of Comparative Examples 1 and 2 in the average polishing speed, the uniformity in wafer, and the number of scratches. In the case of a drop of hardness for each content, though mixing with 45 phr, which is a large amount, the polishing pads of the present invention have a high density of 095 g/cm$^3$ and a hardness of 65 D far higher than 54 D of Comparative Example 2 containing pores and just a little lower than 68 D of Comparative Example 1 used as a hard pad having a high hardness. Also, in the case of the polishing speed, the number of scratches, and the uniformity in wafer, the polishing pads of the present invention have relatively higher than those of Comparative Examples 1 and 2 and show stable numerical values.

Example 5

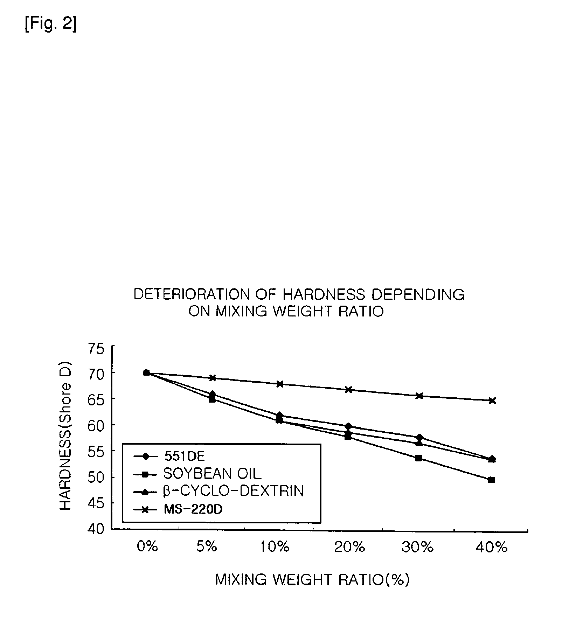

A urethane cake was prepared by using a method similar to that of Example 1 by mixing with the core formed of a liquid organic material encapsulated in a polymer shell.
In this case, the MS-220D was added and mixed by a volume ratio of 5%, 10%, 20%, 30%, and 40% of a volume of a polymer matrix, thereby preparing five polishing pads. A hardness of each of the polishing pads was measured. A result of the measurement is shown in FIG 2

Comparative Example 3

A urethane cake was prepared by using a method similar to that of Comparative Example 2 by using EXPANCEL 551DE that was a micro shell formed of a copolymer of chloride vinylidene and acrylonitrile instead of the liquid organic core encapsulated in a polymer shell.
In this case, five polishing pads were prepared by adding and mixing with contents of the EXPANCEL 551DE by volume ratios of 5%, 10%, 20%, 30%, and 40% of a volume of a polymer matrix, respectively. A hardness of each of the polishing pads was measured. A result of the measurement is shown in FIG 2.

Comparative Example 4

A urethane cake was prepared by using a method similar to Example 5 by using soybean oil instead of the liquid organic core encapsulated in a polymer shell.
In this case, five polishing pads were prepared by adding and mixing with contents of the soybean oil by volume ratios of 5%, 10%, 20%, 30%, and 40% of a volume of a polymer matrix, respectively. A hardness of each of the polishing pads was measured. A result of the measurement is shown in FIG 2.

Comparative Example 5

A urethane cake was prepared by using a method similar to Example 5 by using - cyclo-dextrin instead of the liquid organic core encapsulated in a polymer shell.
In this case, five polishing pads were prepared by adding and mixing with contents of the -cyclo-dextrin by volume ratios of 5%, 10%, 20%, 30%, and 40% of a volume of a polymer matrix, respectively. A hardness of each of the polishing pads was measured. A result of the measurement is shown in FIG. 2
FIG. 2 is a graph illustrating the results of measuring hardness changes of the polishing pads prepared by Example 5 and Comparative Examples 3 to 5. Referring to FIG 2, it may be known that there is little difference between the polishing pad prepared by mixing with the core of the liquid organic material and the conventional polishing pads. Therefore, it may be known that the hardness of the polishing pad is maintained, thereby maintaining polishing efficiency and flatness of wafer.

**Industrial Applicability**

An aspect of the present invention provides a polishing pad prepared by mixing a polymer matrix with a core in the form of a liquid organic material encapsulated in a polymer shell to obtain higher polishing efficiency, more stable polishing performance, and flatness of wafer. Accordingly, the polishing pad may have a hardness more than 60 D to improve the polishing efficiency and the flatness of wafer, which may be of importance to integrate a semiconductor process. Defects caused by hollow subsidiary materials having a low density may be reduced by using the liquid organic material encapsulated in the polymer shell having a density similar to a urethane. In a urethane reaction at a temperature of 130°C, a size of the core may be uniformly maintained, thereby obtaining high polishing efficiency and stably producing polishing pads.

**Claims**

1. A chemical mechanical polishing (CMP) pad comprising a core of a polymer shell encapsulating a liquid organic material with one of a boiling point and a decomposition point of 130 °C or more in a polymer matrix, the CMP pad having open pores formed by the core on a polishing surface thereof,
wherein the liquid organic material is at least one selected from a group consisting of one of a hydrocarbon solvent and a modified hydrocarbon solvent formed of a mixture of CnHm in which n is an integer from 9 to 16; phthalate plasticizers; liquid oligomers with a molecular weight about 10,000 or less and a viscosity about $5 \times 10^6$ cps/20°C or less; solvents with a high boiling point such as N,N-dimethylformamide (DMF); and a mixture thereof.

2. The CMP pad of claim 1, wherein the polymer shell has a density of 0.5 to 1,5 g/cm$^3$.

3. The CMP pad of claim 1, wherein the polymer shell is selected from a group consisting of polystyrene-acrylate copolymer, polyacrylonitrile, polyacrylate, polycarbonate, silicone, epoxy, polyurethane, polyester, nylon, polyvinylchloride, polystyrene, polypropylene, polyethylene, acrylic resin, and a mixture thereof.

4. (Canceled)

5. The CMP pad of claim 1, wherein the phthalate plasticizers are selected from a group consisting of dioctyl phthalate, diisononyl phthalate, dioctyl adipate, trioctyl trimellitate, dibutyl phthalate, and diisodecyl phthalate.

6. The CMP pad of claim 1, wherein the liquid oligomers are selected from a group consisting of polypropylene glycol, polyethylene glycol, polymethylene glycol; ester polyol, carbonate polyol, poly Hanstoff dispersion, and polyisocyanate polyaddition.

7. The CMP pad of claim 1, wherein the polymer matrix is selected from a group consisting of polyurethane, polyester, nylon, acryl, epoxy, silicone, polycarbonate, and a mixture thereof.

8. The CMP pad of claim 1, wherein the core is contained in the polymer matrix by 1 to 200 part per hundred resin (phr).

9. The CMP pad of claim 1, wherein the core has a size of 1 to 200 $\mu$m.

10. The CMP pad of claim 1, wherein the pad has a hardness of 60 Shore D_or more.

11. A method of producing a CMP pad, the method comprising:

   producing a polymer matrix by a two-liquid casting method using a main material and a hardener; and
   mixing the polymer matrix with a core of a polymer shell encapsulating a liquid organic material with one of a boiling point and a decomposition point of 130 °C or more,
   wherein the liquid organic material is at least one selected from a group consisting of one of a hydrocarbon solvent and a modified hydrocarbon solvent formed of a mixture of CnHm in which n is an integer from 9 to 16; phthalate plasticizers; liquid oligomers with a molecular weight about 10,000 or less and a viscosity about $5 \times 10^8$ cps/20°C or less; solvents with a high boiling point such as N,N-dimethylformamide (DMF); and a mixture thereof.

12. The method of claim 11, wherein the core of the polymer shell encapsulating the liquid organic material is mixed with at least one of the main material and the hardener.

13. The method of claim 11, wherein the core of the polymer shell is contained in the polymer matrix by 1 to 200 phr.

14. The method of claim 11, wherein the polymer matrix is selected from a group consisting of polyurethane, polyester, nylon, acryl, epoxy, silicone, polycarbonate, and a mixture thereof.

15. The method of claim 11, wherein the polymer shell has a density of 0.5 to 1.5 g/cm$^3$,

16. The method of claim 11, wherein the polymer shell is selected from a group consisting of polystyrene-acrylate copolymer, polyacrylonitrile, polyacrylate, polycarbonate, silicone, epoxy, polyurethane, polyester, nylon, polyvinylchloride, polystyrene, polypropylene, polyethylene, acrylic resin, and a mixture thereof.

**17.** The method of claim 11, wherein the phthalate plasticizer is selected from a group consisting of dioctyl phthalate, diisononyl phthalate, dioctyl adipate, trioctyl trimellitate, dibutyl phthalate, and diisodecyl phthalate.

**18.** The method of claim 11, wherein the liquid oligomers is selected from a group consisting of polypropylene glycol, polyethylene glycol, polymethylene glycol, ester polyol, carbonate polyol, poly hanstoff dispersion, and polyisocyanate polyaddition.

**Patentansprüche**

**1.** Ein Polster zum chemisch-mechanischen Polieren (CMP) umfassend einen Kern aus einem Polymermantel, der ein flüssiges organisches Material, das entweder einen Siedepunkt oder eine Zersetzungstemperatur von 130 °C oder mehr besitzt, einschließt, in einer Polymermatrix, wobei das CMP-Polster offene Poren besitzt, die der Kern auf einer Polieroberfläche bildet, wobei das flüssige organische Material mindestens eines ist, das ausgewählt wird aus der Gruppe bestehend aus einem von einem Kohlenwasserstofflösemittel und einem modifizierten Kohlenwasserstofflösemittel, das durch eine Mischung aus CnHm gebildet wird, wobei n eine ganze Zahl von 9 bis 16 ist; Phthalat-Weichmachern; flüssigen Oligomeren mit einem Molekulargewicht von 10.000 oder weniger und einer Viskosität von $5x10^8$ cps/20°C oder weniger; Lösemitteln mit einem hohen Siedepunkt wie N,N-Dimethylformamid (DMF); sowie einer Mischung daraus.

**2.** Das CMP-Polster nach Anspruch 1, wobei der Polymermantel eine Dichte von 0,5 bis 1,5 g/cm$^3$ besitzt.

**3.** Das CMP-Polster nach Anspruch 1, wobei der Polymermantel ausgewählt ist aus der Gruppe bestehend aus Polystyrolacrylat-Co-Polymer, Polyacrylnitril, Polyacrylat, Polycarbonat, Silikon, Epoxid, Polyurethan, Polyester, Nylon, Polyvinylchlorid, Polystyrol, Polypropylen, Polyethylen, Acrylharz sowie einer Mischung daraus.

**4.** (Gelöscht)

**5.** Das CMP-Polster nach Anspruch 1, wobei die Phthalat-Weichmacher ausgewählt sind aus der Gruppe bestehend aus Dioctylphthalat, Diisononylphthalat, Dioctyladipat, Trioctyltrimellitat, Dibutylphthalat und Diisodecylphthalat.

**6.** Das CMP-Polster nach Anspruch 1, wobei die flüssigen Oligomere ausgewählt sind aus der Gruppe bestehend aus Polypropylenglycol, Polyethylenglycol, Polymethylenglycol, Esterpolyol, Carbonatpolyol, poly-Harnstoff-Dispersion und Polyisocyanat-Polyaddukt.

**7.** Das CMP-Polster nach Anspruch 1, wobei die Polymermatrix ausgewählt ist aus der Gruppe bestehend aus Polyurethan, Polyester, Nylon, Acrylat, Epoxid, Silikon, Polycarbonat sowie einer Mischung daraus.

**8.** Das CMP-Polster nach Anspruch 1, wobei der Kern in der Polymermatrix anteilig mit 1 bis 200 Teil(en) pro Hundert Harz-Einheiten (phr) enthalten ist.

**9.** Das CMP-Polster nach Anspruch 1, wobei der Kern eine Größe von 1 bis 200 $\mu$m besitzt.

**10.** Das CMP-Polster nach Anspruch 1, wobei das Polster eine Härte von 60 Shore D oder mehr besitzt.

**11.** Ein Verfahren zur Herstellung eines CMP-Polsters, wobei das Verfahren umfasst:

Herstellung einer Polymermatrix in einem zwei-Flüssigkeiten-Guss-Verfahren unter Verwendung eines Basismaterials und eines Härtungsmittels; und
Mischen der Polymermatrix mit einem Kern aus einem Polymermantel, der ein flüssiges organisches Material umschließt, welches einen Siedepunkt oder eine Zersetzungstemperatur von 130 °C oder mehr besitzt, wobei das flüssige organische Material mindestens eines ist, das ausgewählt wird aus der Gruppe bestehend aus einem von einem Kohlenwasserstofflösemittel und einem modifizierten Kohlenwasserstofflösemittel, das durch eine Mischung aus CnHm gebildet wird, wobei n eine ganze Zahl von 9 bis 16 ist; Phthalat-Weichmachern; flüssigen Oligomeren mit einem Molekulargewicht von 10.000 oder weniger und einer Viskosität von $5x10^8$ cps/20°C oder weniger; Lösemitteln mit einem hohen Siedepunkt wie N,N-Dimethylformamid (DMF); sowie einer Mischung daraus.

**12.** Das Verfahren nach Anspruch 11, wobei der Kern des Polymermantels, welcher das flüssige organische Material umschließt, mit mindestens einem von dem Basismaterial oder dem Härtungsmittel vermischt ist.

**13.** Das Verfahren nach Anspruch 11, wobei der Kern des Polymermantels in der Polymermatrix anteilig mit 1 bis 200 phr enthalten ist.

**14.** Das Verfahren nach Anspruch 11, wobei die Polymermatrix ausgewählt ist aus der Gruppe bestehend aus Polyurethan, Polyester, Nylon, Acrylat, Epoxid, Silikon, Polycarbonat sowie einer Mischung daraus.

**15.** Das Verfahren nach Anspruch 11, wobei der Polymermantel eine Dichte von 0,5 bis 1,5 g/cm$^3$ besitz.

**16.** Das Verfahren nach Anspruch 11, wobei der Polymermantel ausgewählt ist aus der Gruppe bestehend aus Polystyrolacrylat-Co-Polymer, Polyacrylnitril, Polyacrylat, Polycarbonat, Silikon, Epoxid, Polyurethan, Polyester, Nylon, Polyvinylchlorid, Polystyrol, Polypropylen, Polyethylen, Acrylharz sowie einer Mischung daraus.

**17.** Das Verfahren nach Anspruch 11, wobei die Phthalat-Weichmacher ausgewählt sind aus der Gruppe bestehend aus Dioctylphthalat, Diisononylphthalat, Dioctyladipat, Trioctyltrimellitat, Dibutylphthalat und Diisodecylphthalat.

**18.** Das Verfahren nach Anspruch 11, wobei die flüssigen Oligomere ausgewählt sind aus der Gruppe bestehend aus Polypropylenglycol, Polyethylenglycol, Polymethylenglycol, Esterpolyol, Carbonatpolyol, poly-Harnstoff-Dispersion und Polyisocyanat-Polyaddukt.


## Revendications

**1.** Tampon de polissage mécano-chimique (CMP) comprenant un noyau d'une enveloppe en polymère encapsulant un matériau organique liquide avec un point d'ébullition ou un point de décomposition supérieur ou égal à 130°C dans une matrice polymère, le tampon CMP ayant des pores ouverts formés par le noyau sur une surface de polissage de celui-ci,
dans lequel le matériau organique liquide est au moins un élément choisi dans un groupe constitué de l'un d'un solvant hydrocarboné et d'un solvant hydrocarboné modifié formé d'un mélange de CnHm où n est un nombre entier allant de 9 à 16 ; de plastifiants phtalate ; d'oligomères liquides avec un poids moléculaire inférieur ou égal à environ 10000 et une viscosité inférieure ou égale à environ 5x10$^8$ cps/20°C ; de solvants avec un point d'ébullition élevé tels que le N,N-diméthylformamide (DMF) ; et d'un mélange de ceux-ci.

**2.** Tampon CMP de la revendication 1, dans lequel l'enveloppe en polymère a une densité allant de 0,5 à 1,5 g/cm$^3$.

**3.** Tampon CMP de la revendication 1, dans lequel l'enveloppe en polymère est choisie dans un groupe constitué d'un copolymère de polystyrène-acrylate, de polyacrylonitrile, de polyacrylate, de polycarbonate, de silicone, d'époxy, de polyuréthane, de polyester, de nylon, de polychlorure de vinyle, de polystyrène, de polypropylène, de polyéthylène, de résine acrylique, et d'un mélange de ceux-ci.

**4.** (Annulée)

**5.** Tampon CMP de la revendication 1, dans lequel les plastifiants phtalate sont choisis dans un groupe constitué de phtalate de dioctyle, de phtalate de diisononyle, d'adipate de dioctyle, de trimellitate de trioctyle, de phtalate de dibutyle, et de phtalate de diisodécyle.

**6.** Tampon CMP de la revendication 1, dans lequel les oligomères liquides sont choisis dans un groupe constitué de polypropylène glycol, de polyéthylène glycol, de polyméthylène glycol, d'ester polyol, de carbonate polyol, de dispersion de poly-hanstoff, et de polyaddition de polyisocyanate.

**7.** Tampon CMP de la revendication 1, dans lequel la matrice polymère est choisie dans un groupe constitué de polyuréthane, de polyester, de nylon, d'acryl, d'époxy, de silicone, de polycarbonate et d'un mélange de ceux-ci.

**8.** Tampon CMP de la revendication 1, dans lequel le noyau est présent dans la matrice polymère en une quantité allant de 1 à 200 parties pour cent parties de résine (phr).

9. Tampon CMP de la revendication 1, dans lequel le noyau a une taille allant de 1 à 200 µm.

10. Tampon CMP de la revendication 1, dans lequel le tampon a une dureté Shore D supérieure ou égale à 60.

11. Procédé de production d'un tampon CMP, le procédé comprenant le fait :

de produire une matrice polymère par un procédé de coulée à deux liquides en utilisant un matériau principal et un agent de durcissement ; et
de mélanger la matrice polymère avec un noyau d'une enveloppe en polymère encapsulant un matériau organique liquide avec un point d'ébullition ou un point de décomposition supérieur ou égal à 130°C,
dans lequel le matériau organique liquide est au moins un élément choisi dans un groupe constitué de l'un d'un solvant hydrocarboné et d'un solvant hydrocarboné modifié formé d'un mélange de CnHm où n est un nombre entier allant de 9 à 16 ; de plastifiants phtalate ; d'oligomères liquides avec un poids moléculaire inférieur ou égal à environ 10000 et une viscosité inférieure ou égale à environ $5 \times 10^8$ cps/20°C ; de solvants avec un point d'ébullition élevé tels que le N,N-diméthylformamide (DMF) ; et d'un mélange de ceux-ci.

12. Procédé de la revendication 11, dans lequel le noyau de l'enveloppe en polymère encapsulant le matériau organique liquide est mélangé avec au moins l'un du matériau principal et de l'agent de durcissement.

13. Procédé de la revendication 11, dans lequel le noyau de l'enveloppe en polymère est présent dans la matrice polymère en une quantité allant de 1 à 200 phr.

14. Procédé de la revendication 11, dans lequel la matrice polymère est choisie dans un groupe constitué de polyuréthane, de polyester, de nylon, d'acryl, d'époxy, de silicone, de polycarbonate et d'un mélange de ceux-ci.

15. Procédé de la revendication 11, dans lequel l'enveloppe en polymère a une densité allant de 0,5 à 1,5 g/cm³.

16. Procédé de la revendication 11, dans lequel l'enveloppe en polymère est choisie dans un groupe constitué d'un copolymère de polystyrène-acrylate, de polyacrylonitrile, de polyacrylate, de polycarbonate, de silicone, d'époxy, de polyuréthane, de polyester, de nylon, de polychlorure de vinyle, de polystyrène, de polypropylène, de polyéthylène, de résine acrylique, et d'un mélange de ceux-ci.

17. Procédé de la revendication 11, dans lequel le plastifiant phtalate est choisi dans un groupe constitué de phtalate de dioctyle, de phtalate de diisononyle, d'adipate de dioctyle, de trimellitate de trioctyle, de phtalate de dibutyle et de phtalate de diisodécyle.

18. Procédé de la revendication 11, dans lequel, les oligomères liquides sont choisis dans un groupe constitué de polypropylène glycol, de polyéthylène glycol, de polyméthylène glycol, d'ester polyol, de carbonate polyol, de dispersion poly-hanstoff et de polyaddition de polyisocyanate.

[Fig. 1]

[Fig. 2]

DETERIORATION OF HARDNESS DEPENDING
ON MIXING WEIGHT RATIO

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4927432 A
- US 5578362 A
- US 6685540 B
- US 6790883 B
- KR 0495404
- KR 20010005435
- US 6777455 B